# EUROPÄISCHE PATENTSCHRIFT

(11) **EP 3 807 995 B1**
(45) Veröffentlichungstag und Bekanntmachung des Hinweises auf die Patenterteilung: **24.05.2023**
(21) Anmeldenummer: 19727653.8
(22) Anmeldetag: 29.05.2019
(51) Int. Cl.: H03K 17/975, G01D 5/241

(54) **VERFAHREN ZUM BETÄTIGEN EINER BEDIENVORRICHTUNG, BEI WELCHEM ZUMINDEST EIN KORREKTURWERT ERMITTELT WIRD, BEDIENVORRICHTUNG SOWIE HAUSHALTSGERÄT**
METHOD FOR ACTUATING AN OPERATING DEVICE, WHEREIN AT LEAST ONE CORRECTION VALUE IS DETERMINED, OPERATING DEVICE AND DOMESTIC APPLIANCE
PROCÉDÉ D'ACTIONNEMENT D'UN DISPOSITIF DE COMMANDE SELON LEQUEL AU MOINS UNE VALEUR DE CORRECTION EST DÉTERMINÉE, AINSI QUE DISPOSITIF DE COMMANDE ET APPAREIL MÉNAGER

(30) Priorität: 14.06.2018 DE 102018209515
(43) Veröffentlichungstag der Anmeldung: 21.04.2021
(73) Patentinhaber: BSH Hausgeräte GmbH, 81739 München (DE)
(72) Erfinder: FORSTER, Florian, 83346 Bergen (DE)
(86) Internationale Anmeldenummer: PCT/EP2019/063912
(87) Internationale Veröffentlichungsnummer: WO 2019/238422

(56) Entgegenhaltungen:
- EP-A1- 3 002 562
- FR-A1- 3 056 475

## Beschreibung

Die Erfindung betrifft ein Verfahren zum Betätigen einer Bedienvorrichtung für ein Haushaltsgerät. Mittels eines Bedienelements der Bedienvorrichtung wird durch Betätigen des Bedienelements mit einer ersten Betätigungsart aus einer ersten Ruhestellung in eine erste Bedienstellung eine erste Funktion des Haushaltsgeräts eingestellt. Durch Betätigen des Bedienelements mit einer zur ersten Betätigungsart unterschiedlichen zweiten Betätigungsart aus einer zweiten Ruhestellung des Bedienelements in zumindest eine von einer Vielzahl von Zwischenstellungen des Bedienelements wird zum Einstellen eines Werts ein Einstellparameter einer zweiten Funktion des Haushaltsgeräts eingestellt. Zur Betätigung der ersten Funktion des Haushaltsgeräts wird zumindest ein erster Kapazitätswert der Bedienvorrichtung mittels einer kapazitiven Erfassungseinrichtung der Bedienvorrichtung erfasst und zur Bestimmung des Einstellparameters wird zumindest ein zweiter Kapazitätswert mittels der kapazitiven Erfassungseinrichtung erfasst. Ferner betrifft die Erfindung eine Bedienvorrichtung sowie ein Haushaltsgerät.

Aus dem Stand der Technik sind bereits Bedienvorrichtungen bekannt, mittels welchen durch eine erste Betätigungsart und eine zweite Betätigungsart eine erste Funktion und eine zweite Funktion des Haushaltsgeräts betätigt werden können.

Beispielsweise offenbart die EP 3 002 562 A1 eine Bedienvorrichtung mit einer kapazitiven Erfassungseinrichtung, welche eine Leiterplatte und eine Vielzahl von leitfähigen Sektoren aufweist, welche Kapazitäten erzeugen. Ferner weist die Bedienvorrichtung einen Rotor auf, der im Dreh- und/oder Axialverschiebungsmodus bezüglich der Leiterplatte montiert ist, wobei der Rotor aus einem dielektrischen Material hergestellt ist und einen Umfangsschlitz aufweist, der mit den leitfähigen Sektoren in Registern angeordnet ist. Ferner weist die Bedienvorrichtung eine Steuereinheit auf, die elektrisch mit den leitfähigen Sektoren in solcher Weise verbunden ist, um die Kapazität jedes Kondensators zu erfassen, der durch die leitfähigen Sektoren erzeugt wird. Die Steuereinheit ist so eingestellt, dass sie die Kapazitätsänderung zwischen den Kondensatoren während der Rotation und/oder Axialverschiebung des Rotors erfasst, um die Winkel- und/oder Axialposition des Rotors zu erfassen.

Nachteilig an der bekannten Bedienvorrichtung ist jedoch, dass auf die Erfassung der Kapazitäten störende Größen, wie beispielsweise Leckströme und/oder Temperaturdrift und/oder Alterung und/oder Fertigungstoleranzen und/oder Montagetoleranzen und/oder Bauteiltoleranzen, einwirken, welche die Ergebnisse stark verfälschen können und erhebliche Fehler beim Bestimmen eines Winkels des Bedienelements verursachen können. Der Einfluss dieser Störgrößen auf die Kapazitätsmessung ist mit vertretbarem Aufwand nicht vermeidbar und es ist eine digitale Korrektur notwendig. Die Ermittlung der Korrekturparameter ist allerdings im statischen Zustand ohne vorherige Kenntnis des Drehwinkels unmöglich, was zu Einschränkungen der Zuverlässigkeit des zu bestimmenden Winkels führt.

Aufgabe der vorliegenden Erfindung ist es, ein Verfahren, eine Bedienvorrichtung sowie ein Haushaltsgerät zu schaffen, mittels welchem eine zuverlässigere Betätigung der Bedienvorrichtung realisiert werden kann.

Diese Aufgabe wird durch ein Verfahren, eine Bedienvorrichtung sowie ein Haushaltsgerät gemäß den unabhängigen Patentansprüchen gelöst.

Ein Aspekt der Erfindung betrifft ein Verfahren zum Betätigen einer Bedienvorrichtung für ein Haushaltsgerät. Mittels eines Bedienelements der Bedienvorrichtung wird durch Betätigen des Bedienelements mit einer ersten Betätigungsart aus einer ersten Ruhestellung in eine erste Bedienstellung eine erste Funktion des Haushaltsgeräts eingestellt. Durch Betätigen des Bedienelements mit einer zur ersten Betätigungsart unterschiedlichen zweiten Betätigungsart aus einer zweiten Ruhestellung des Bedienelements in zumindest eine von einer Vielzahl von Zwischenstellungen des Bedienelements wird zum Einstellen eines Werts ein Einstellparameter einer zweiten Funktion des Haushaltsgeräts eingestellt. Zur Betätigung der ersten Funktion des Haushaltsgeräts wird zumindest ein erster Kapazitätswert der Bedienvorrichtung mittels einer kapazitiven Erfassungseinrichtung der Bedienvorrichtung erfasst und zur Bestimmung des Einstellparameters wird zumindest ein zweiter Kapazitätswert mittels der kapazitiven Erfassungseinrichtung erfasst.

Es ist vorgesehen, dass bei der ersten Betätigungsart aus der ersten Ruhestellung in die erste Bedienstellung der erste Kapazitätswert erfasst wird und in Abhängigkeit des erfassten ersten Kapazitätswerts zumindest ein Korrekturwert bestimmt wird, welcher bei der Bestimmung des zweiten Kapazitätswerts zur Bestimmung des Einstellparameters der zweiten Funktion berücksichtigt wird.

Dadurch kann eine zuverlässige Korrektur des zweiten Kapazitätswerts und somit eine zuverlässige Betätigung der Bedienvorrichtung, insbesondere bezüglich der zweiten Betätigungsart, ermöglicht werden. Somit kann ein aktuell gültiger Korrekturwert bestimmt werden, sodass auf die aktuelle Situation angepasst der zweite Kapazitätswert zuverlässig bestimmt werden kann. Dadurch kann der störende Einfluss der eingangs genannten Störgrößen minimiert beziehungsweise kompensiert werden, so dass eine zuverlässige Winkelerfassung des Bedienelements ermöglicht ist.

Insbesondere kann vorgesehen sein, dass eine Vielzahl, welche insbesondere mehr als eins entspricht, von Korrekturwerten für die Bedienvorrichtung ermittelt wird.

Bevorzugt ist vorgesehen, dass die Bedienvorrichtung als Brennregler-Drehknopf ausgebildet ist. Insbesondere weist das Bedienelement bei der zweiten Betätigungsart, insbesondere beim Drehen, eine Vielzahl von möglichen Zwischenstellungen auf. Diese Zwischenstellungen können zwischen der zweiten Ruhestellung und einer Endstellung bezüglich der zweiten Betätigungsart sein. Die Zwischenstellungen können insbesondere stufenlos eingestellt werden. Es ist auch eine nicht-stufenlose Einstellung möglich. Insbesondere wird in den verschiedenen Zwischenstellungen der Einstellparameter unterschiedlich eingestellt. Insbesondere kann mittels des Einstellparameters eine aktuelle Leistungsstufe gesteuert werden. Insbesondere kann dadurch die Leistungsstufe auf einer Anzeigeeinrichtung des Haushaltsgeräts oder der Bedienvorrichtung zuverlässig und präzise angezeigt werden. Ebenfalls möglich ist, dass bei einer Bedienvorrichtung für ein Gas-Kochfeld in den unterschiedlichen Zwischenstellungen der Gasfluss unterschiedlich eingestellt wird.

Ferner weist die kapazitive Erfassungseinrichtung zumindest einen Rotor mit zumindest einem Rotorsensorelement und einen Stator mit zumindest zwei Statorsensorelementen auf, wobei zumindest der erste und der zweite Kapazitätswert in Abhängigkeit einer positionellen Veränderung des Rotorsensorelements zu den Statorsensorelementen erzeugt werden. Dadurch ist eine zuverlässige Kapazitätswerterfassung ermöglicht. Insbesondere in Abhängigkeit der positionellen Veränderung der jeweiligen Sensorelemente zueinander kann dann zuverlässig der erste Kapazitätswert und der zweite Kapazitätswert und eventuelle weitere Kapazitätswerte erfasst werden. Mittels dieser Ausgestaltungsform kann somit eine zuverlässige Erfassung der Kapazitätswerte erfolgen, wodurch es zu einer zuverlässigen Betätigung der Bedienvorrichtung kommen kann.

Insbesondere kann vorgesehen sein, dass der Stator eine Vielzahl von Statorsensorelementen, insbesondere drei, insbesondere mehr als drei, insbesondere zwölf, Statorsensorelemente aufweist. Dadurch ist eine positionsgenaue Bestimmung des Stators ermöglicht.

Ebenfalls vorteilhaft ist, wenn für ein jeweiliges Statorsensorelement ein jeweiliger Korrekturwert bestimmt wird und bei der Bestimmung des zweiten Kapazitätswerts der jeweilige Korrekturwert eines jeweiligen Statorsensorelements berücksichtigt wird. Mit anderen Worten wird für jedes Statorsensorelement ein einzelner Korrekturwert bestimmt. Mit anderen Worten wird durch den Korrekturwert ein einzelner Messfehler eines jeden Statorsensorelements erfasst. Durch die Ermittlung eines jeweiligen Korrekturwerts eines jeden Statorsensorelements ist es insbesondere ermöglicht, dass der zweite Kapazitätswert zuverlässig korrigiert und bestimmt werden kann. Dadurch ist eine zuverlässige Bestimmung der Position des Bedienelements ermöglicht, wodurch es zu einer zuverlässigen Betätigung der Bedienvorrichtung kommen kann.

Gemäß einer vorteilhaften Ausgestaltungsform wird als erste Betätigungsart des Bedienelements das Bedienelement entlang einer Achse des Bedienelements gedrückt und als zweite Betätigungsart das Bedienelement um die Achse gedreht. Dadurch kann eine Drück-Dreh-Bedienvorrichtung realisiert werden. Dadurch können zwei unterschiedliche Betätigungsarten realisiert werden. Dies führt zu einer erhöhten Funktionalität und zu einer zuverlässigen Bedienung, da insbesondere die zwei Betätigungsarten in ihrer Betätigungsart unterschiedlich ausgebildet sind und einfach bezüglich der Kapazitätswertveränderungen zu unterscheiden sind. Insbesondere durch die hohe Unterscheidungskraft der Betätigungsarten kann zuverlässig der erste Kapazitätswert und der zweite Kapazitätswert erfasst werden, ohne dass es zu Fehlinterpretationen der jeweiligen Kapazitätswerte kommen kann. Dadurch ist eine zuverlässige Bedienung der Bedienvorrichtung ermöglicht.

Es hat sich weiterhin als vorteilhaft erwiesen, wenn nach dem Betätigen mittels der ersten Betätigungsart des Bedienelements aus der Ruhestellung in die erste Bedienstellung das Bedienelement mittels einer Rückstelleinrichtung der Bedienvorrichtung automatisch in die erste Ruhestellung rückgestellt wird. Insbesondere kann die Rückstelleinrichtung als Feder ausgebildet sein und somit mittels einer Federkraft das Bedienelement in die erste Ruhestellung rückgestellt werden. Dadurch ist eine zuverlässige Bedienung der Bedienvorrichtung realisiert, da das Bedienelement zuverlässig in die erste Ruhestellung zurückgeführt werden kann.

Ebenfalls vorteilhaft ist, wenn das Betätigen des Bedienelements mit der ersten Betätigungsart zeitlich vor dem Betätigen des Bedienelements mit der zweiten Betätigungsart erfolgt und das Bedienelement aus der gleichen Ruhestellung der ersten Betätigungsart gedrückt wird, aus der das Bedienelement aus der Ruhestellung der zweiten Betätigungsart betätigt wird, sodass die erste Ruhestellung der zweiten Ruhestellung entspricht. Dadurch ist eine zuverlässige Erfassung der Kapazitätswerte ermöglicht. Insbesondere ist es dadurch ermöglicht, dass nach dem Betätigen mit der ersten Betätigungsart eine direkte Betätigung mit der zweiten Betätigungsart ermöglicht ist. Somit kann die zweite Funktion des Haushaltsgeräts direkt nach der Betätigung der ersten Funktion eingestellt werden. Beispielsweise kann bei der Ausgestaltungsform der Bedienvorrichtung als Brennregler-Drehknopf mittels der ersten Funktion ein Zünden des Brenners ausgelöst werden. Das Zünden des Brenners ist erforderlich und erfolgt insbesondere vor der zweiten Funktion des Haushaltsgeräts. Insbesondere kann mittels des Einstellparameters eine aktuelle Leistungsstufe gesteuert werden. Insbesondere kann dadurch die Leistungsstufe auf einer Anzeigeeinrichtung des Haushaltsgeräts oder der Bedienvorrichtung zuverlässig und präzise angezeigt werden. Ferner kann durch das Betätigen des Bedienelements in die unterschiedlichen Zwischenstellungen der Gasfluss eingestellt werden.

Mit anderen Worten wird bei einer Ausgestaltungsform als Brennregler-Drehknopf vor Beginn des Garprozesses der Lebensmittel der Brennregler-Drehknopf gedrückt, um eine Zündung zu generieren. Insbesondere dies kann ausgenutzt werden, um den entsprechenden Korrekturwert für den zweiten Kapazitätswert, welcher der Einstellung des Gases dienen kann, zu ermitteln. Insbesondere bevor der Brennregler-Drehknopf gedrückt wird, ist eine Erfassung des Winkels nicht erforderlich, weil zu diesem Zeitpunkt aufgrund der mechanischen Bauweise des Brennregler-Drehknopfes dieser ohnehin in der ersten Ruhestellung ist. Insbesondere durch Zurückführung in diese Ruhestellung und der danach folgenden Drehung aus dieser Ruhestellung kann dann die Einstellung des Gases für das Haushaltsgerät durchgeführt werden. Dadurch ist es ermöglicht, dass zuverlässig eine Erfassung des Drehwinkels des Bedienelements erreicht werden kann, wodurch es zu einer zuverlässigen Betätigung der Bedienvorrichtung kommen kann.

Ebenfalls vorteilhaft ist, wenn in Abhängigkeit des zweiten Kapazitätswert ein relativer Winkel des Stators zum Rotor bestimmt wird und in Abhängigkeit des Winkels der Einstellparameter eingestellt wird. Insbesondere weist das Rotorsensorelement eine Aussparung auf, so dass der Winkel des Rotors, aufgrund der geometrischen Form des Rotors mit der Aussparung, zum Stator über die Kapazitätswerte bestimmt werden kann. Durch die Bestimmung des relativen Winkels kann der Einstellparameter zuverlässig bestimmt werden, wodurch es zu einer zuverlässigen Betätigung der Bedienvorrichtung kommen kann.

Gemäß einer weiteren vorteilhaften Ausgestaltungsform können der erste und der zweite Kapazitätswert durch Auswerten von Statorkapazitätswerten der zumindest zwei Statorsensorelemente bestimmt werden. Insbesondere können hierzu jeweils die Einzelkapazitäten oder die Koppelkapazitäten der Statorsensorelemente bestimmt werden. Beispielsweise kann zur Bestimmung der Einzelkapazitäten ein jedes der Statorsensorelemente geerdet sein und die jeweilige Kapazitätsveränderung einzeln gegenüber der Erde gemessen werden. Zur Bestimmung der Koppelkapazitäten können insbesondere die jeweiligen Kapazitäten zwischen den zumindest zwei Statorsensorelementen gemessen werden. Dadurch ist eine zuverlässige Bestimmung des ersten und des zweiten Kapazitätswerts ermöglicht. Dadurch kann eine zuverlässige Betätigung der Bedienvorrichtung realisiert werden.

In einer weiteren vorteilhaften Ausführungsform kann der erste Kapazitätswert durch Aufsummierung der jeweiligen Statorkapazitätswerte beim Betätigen mit der ersten Betätigungsart bestimmt werden. Dies hat den Hintergrund darin, da der Rotor mehrere Sensorelemente überdeckt und nicht bekannt ist, welche Sensorelemente aktuell überdeckt werden. Somit kann der aktuelle Korrekturwert zuverlässig bestimmt werden, sodass eine zuverlässige Betätigung der Bedienvorrichtung realisiert werden kann.

Ebenfalls vorteilhaft ist, wenn zum Bestimmen des ersten Kapazitätswerts zeitliche Veränderungen der Statorkapazitätswerte als Statorsignale mittels eines Bandpasses gefiltert werden, sodass die erste Betätigungsart erfasst werden kann. Insbesondere ist vorgesehen, dass der Bandpass sperrend für langsame zeitliche Veränderungen des Statorsignals, welche beispielsweise aufgrund von Driften entstehen (zum Beispiel bei Temperaturänderungen) ist. Für zeitlich sehr schnelle Veränderungen des Statorsignals ist der Bandpass ebenfalls sperrend, da diese Störsignale sind, welche beispielsweise durch elektromagnetische Einkopplung von außen entstehen können. Insbesondere kann vorgesehen sein, dass der Bandpass durchlässig für zeitliche Veränderungen der Statorsignale ist, die durch die erste Betätigungsart, insbesondere durch ein Drücken und Loslassen des Bedienelements, entstehen. Dadurch ist eine zuverlässige Erkennung der ersten Betätigungsart ermöglicht, wodurch der erste Kapazitätswert und der daraus bestimmte Korrekturwert zuverlässig bestimmt werden können.

In einer weiteren vorteilhaften Ausgestaltungsform können die Statorsignale der Statorkapazitätswertveränderungen mit einer Frequenz von > 0,1 Hz und/oder < 100 Hz mittels des Bandpasses herausgefiltert werden. Insbesondere können dadurch die langsamen Veränderungen des Signals und die sehr schnellen Veränderungen des Signals zuverlässig herausgefiltert werden. Insbesondere ist dadurch eine zuverlässige Detektion der ersten Betätigungsart ermöglicht. Dadurch kann zuverlässig der erste Kapazitätswert und der entsprechende Korrekturwert ermittelt werden. Somit ist eine zuverlässige Betätigung der Bedienvorrichtung ermöglicht.

Es hat sich weiterhin als vorteilhaft erwiesen, wenn mittels des Bandpasses ein Dauerdrückvorgang als Dauerbetätigung erkannt wird und beim Erkennen eines Dauerdrückvorgangs eine Bestimmung des Korrekturwerts unterdrückt wird.

Insbesondere kann aufgrund von der Unterdrückung des zu langsamen Loslass-Signals durch den Bandpasses ein entsprechendes Unterdrücken durchgeführt werden. Dadurch kann eine Betätigung des Bedienelements beziehungsweise ebenfalls eine Fehlbetätigung des Bedienelements zuverlässig erfasst werden.

Ebenfalls vorteilhaft ist, wenn die erste Betätigungsart mittels einer Komparatoreinheit mit einer Hysterese der Bedienvorrichtung detektiert wird. Insbesondere ist zum Schalten der Komparatoreinheit eine Mindestamplitude erforderlich. Insbesondere kann mittels der Komparatoreinheit eine Mehrfachtriggerung zur Korrektur unterdrückt werden. Dadurch kann einfach und dennoch zuverlässig die erste Betätigungsart detektier werden.

Ein weiterer Aspekt der Erfindung betrifft eine Bedienvorrichtung für ein Haushaltsgerät mit einem Bedienelement, welches durch eine erste Betätigungsart und eine zweite Betätigungsart betätigbar ist, und mit einer kapazitiven Erfassungseinrichtung, wobei die Bedienvorrichtung dazu ausgebildet ist, ein Verfahren nach dem vorhergehenden Aspekt durchzuführen.

Ein nochmals weiterer Aspekt der Erfindung betrifft ein Haushaltsgerät zum Zubereiten von Lebensmitteln, insbesondere ein Gaskochfeld, mit einer Bedienvorrichtung nach dem vorhergehenden Aspekt.

Vorteilhafte Ausgestaltungsformen des Verfahrens sind als vorteilhafte Ausgestaltungsformen der Bedienvorrichtung sowie des Haushaltsgeräts anzusehen. Die Bedienvorrichtung sowie das Haushaltsgerät weisen dazu gegenständliche Merkmale auf, welche eine Durchführung des Verfahrens beziehungsweise eine vorteilhafte Ausgestaltungsform davon ermöglichen.

Mit Angaben "oben", "unten", "vorne", "hinten", "horizontal", "vertikal", etc. sind bei bestimmungsgemäßen Gebrauch und bestimmungsgemäßen Anordnung des Bauteils und bei einem dann insbesondere vor dem Bauteil stehenden und in Richtung des Bauteils blickenden Beobachters gegebenen Positionen und Orientierungen angegeben.

Ausführungsbeispiele der Erfindung werden nachfolgend anhand schematischer Zeichnungen erläutert. Es zeigen:
- Fig. 1: eine schematische Ansicht einer Ausführungsform eines Haushaltsgeräts;
- Fig. 2: eine schematische Perspektivansicht einer Ausführungsform einer Bedienvorrichtung;
- Fig. 3: eine schematische Draufsicht auf eine Ausführungsform einer Bedienvorrichtung;
- Fig. 4: eine weitere schematische Ansicht einer Ausführungsform der Bedienvorrichtung.

In den Figuren werden gleiche oder funktionsgleiche Elemente mit den gleichen Bezugszeichen versehen.

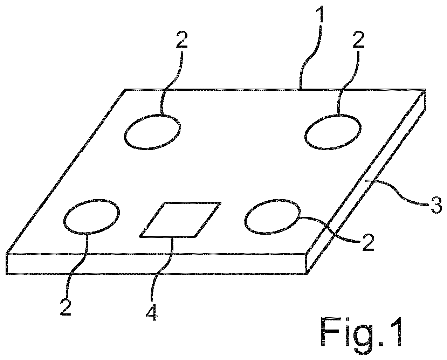

Fig. 1 zeigt eine schematische Perspektivansicht eines Haushaltsgeräts 1. Das Haushaltsgerät 1 ist insbesondere als Kochfeld, insbesondere als Gas-Kochfeld, ausgebildet. Das Haushaltsgerät 1 weist zumindest eine Kochzone 2, im vorliegenden Ausführungsbeispiel vier Kochzonen 2 auf, welche beheizbar sind. Ferner weist das Haushaltsgerät 1 eine Kochfeldplatte 3 auf, die aus Glas oder Glaskeramik sein kann, und welche die Kochzonen 2 aufweist.

Das Haushaltsgerät 1 weist ferner eine Bedienvorrichtung 4 auf, wobei mittels der Bedienvorrichtung 4 die Kochzonen 2 bedient beziehungsweise gesteuert werden können. Insbesondere kann eine Heizeinrichtung, insbesondere ein Gasfluss, des Haushaltsgeräts 1, mittels der Bedienvorrichtung gesteuert werden.

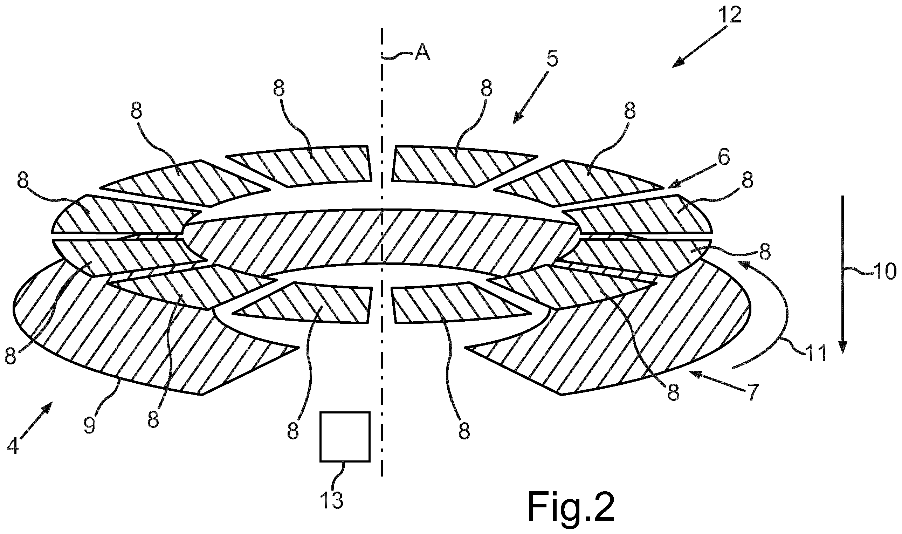

Fig. 2 zeigt eine schematische Perspektivansicht einer Ausführungsform der Bedienvorrichtung 4. Die Bedienvorrichtung 4 weist dazu ein Bedienelement 5 auf, welches im vorliegenden Ausführungsbeispiel einen Stator 6 und einen Rotor 7 aufweisen kann. Der Stator 7 weist zumindest zwei Statorsensorelemente 8, im vorliegenden Ausführungsbeispiel insbesondere 12 Statorsensorelemente 8, auf. Der Rotor 7 weist zumindest ein Rotorsensorelement 9 auf.

Es ist insbesondere vorgesehen, dass ein erster Kapazitätswert 17a und/oder ein zweiter Kapazitätswert 17b durch eine positionelle Veränderung des Rotorsensorelements 9 zu den Statorsensorelementen 8 erzeugt wird.

Es ist vorgesehen, dass mittels des Bedienelements 5 durch Betätigen des Bedienelements 5 mit einer ersten Betätigungsart 10 aus einer ersten Ruhestellung in eine erste Bedienstellung eine erste Funktion des Haushaltsgeräts 1 eingestellt wird. Durch Betätigen des Bedienelements 5 mit einer zur ersten Betätigungsart 10 unterschiedlichen zweiten Betätigungsart 11 aus einer zweiten Ruhestellung des Bedienelements in zumindest eine von einer Vielzahl von Zwischenstellungen des Bedienelements 5 zum Einstellen eines Werts ein Einstellparameter einer zweiten Funktion des Haushaltsgeräts 1 eingestellt. Zur Betätigung der ersten Funktion des Haushaltsgeräts 1 wird zumindest der erste Kapazitätswert 17a der Bedienvorrichtung 5 mittels einer kapazitiven Erfassungseinrichtung 12 der Bedienvorrichtung 4 erfasst und zur Bestimmung des Einstellparameters wird zumindest der zweite Kapazitätswert 17b mittels der kapazitiven Erfassungseinrichtung 12 erfasst.

Es ist vorgesehen, dass bei der ersten Betätigungsart 10 aus der ersten Ruhestellung in die erste Bedienstellung der erste Kapazitätswert 17a erfasst wird und in Abhängigkeit des erfassten ersten Kapazitätswert 17a ein Korrekturwert K bestimmt wird, welcher bei der Bestimmung des zweiten Kapazitätswerts 17b zur Bestimmung des Einstellparameters der zweiten Funktion berücksichtigt wird.

Bevorzugt ist vorgesehen, dass die Bedienvorrichtung 4 als Brennregler-Drehknopf ausgebildet ist. Insbesondere weist das Bedienelement 5 bei der zweiten Betätigungsart 11, insbesondere beim Drehen, eine Vielzahl von möglichen Zwischenstellungen auf. Diese Zwischenstellungen können zwischen der zweiten Ruhestellung und einer Endstellung bezüglich der zweiten Betätigungsart 11 sein. Die Zwischenstellungen können insbesondere stufenlos eingestellt werden. Insbesondere wird in den verschiedenen Zwischenstellungen der Einstellparameter unterschiedlich eingestellt. Beispielsweise kann bei einer Bedienvorrichtung 5 für ein Gas-Kochfeld in den unterschiedlichen Zwischenstellungen der Gasfluss unterschiedlich eingestellt werden.

Insbesondere ist vorgesehen, dass als erste Betätigungsart 10 des Bedienelements 5, das Bedienelement 5 entlang einer Achse A des Bedienelements 5 gedrückt wird und als zweite Betätigungsart 11 das Bedienelement 5 um die Achse A gedreht wird.

Ferner kann insbesondere vorgesehen sein, dass nach dem Betätigen mittels der ersten Betätigungsart 10 das Bedienelement 5 aus der ersten Ruhestellung in die erste Bedienstellung das Bedienelement 5 mittels einer Rückstelleinrichtung 13 der Bedienvorrichtung 4 automatisch in die erste Ruhestellung rückgestellt wird.

Ferner kann insbesondere vorgesehen sein, dass das Betätigen des Bedienelements 5 mit der ersten Betätigungsart 10 zeitlich vor dem Betätigen des Bedienelements 5 mit der zweiten Betätigungsart 11 erfolgt, und das Bedienelement 5 aus der gleichen Ruhestellung mit der ersten Betätigungsart 10 betätigt wird, aus der das Bedienelement 5 mit der zweiten Betätigungsart 11 betätigt wird, sodass die erste Ruhestellung der zweiten Ruhestellung entspricht.

Es ist insbesondere vorgesehen, dass für ein jeweiliges Statorsensorelement 8 ein jeweiliger Korrekturwert K bestimmt wird und bei der Bestimmung des zweiten Kapazitätswerts 17b der jeweilige Korrekturwert K eines jeweiligen Statorsensorelements 8 berücksichtigt wird. Insbesondere kann in Abhängigkeit des zweiten Kapazitätswerts 17b ein relativer Winkel des Stators 6 zum Rotor 7 bestimmt werden und in Abhängigkeit des Winkels der Einstellparameter eingestellt werden.

Insbesondere kann vorgesehen sein, dass der erste und der zweite Kapazitätswert 17b durch Auswerten von Statorkapazitätswerten 16 der zumindest zwei Statorsensorelemente 8 bestimmt werden. Insbesondere kann dies über die Ermittlung der Einzelkapazitäten der Statorsensorelemente 8, insbesondere bezüglich einer Erdung der Statorsensorelemente 8, beziehungsweise durch die Ermittlung von Koppelkapazitäten, wobei hierbei die Statorsensorelemente 8 gegeneinander erfasst werden, bestimmt werden.

Insbesondere kann vorgesehen sein, dass der erste Kapazitätswert 17a durch Aufsummierung der jeweiligen Statorkapazitätswerte 16 bei der Betätigung mit der ersten Betätigungsart 10 bestimmt wird.

Die Fig. 2 zeigt weiterhin, dass die Statorsensorelemente 8 und das Rotorsensorelement 9 insbesondere leitend ausgebildet sind, wobei die Statorsensorelemente 8 insbesondere das Rotorsensorelement 9 zumindest teilweise überdecken. Das Rotorsensorelement 9 ist insbesondere nicht galvanisch mit anderen Bauteilen der Bedienvorrichtung 4 verbunden. Insbesondere ist vorgesehen, dass als Kapazitätswerte 17a, 17b die verschiedenen Statorsensorelemente 8 gemessen werden. Diese sind insbesondere abhängig von der Winkellage des Rotors 7.

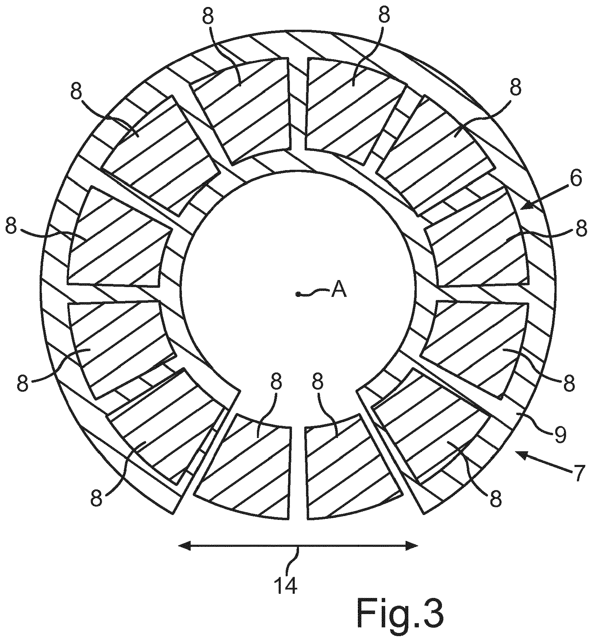

Fig. 3 zeigt in einer schematischen Draufsicht die Bedienvorrichtung 4 gemäß Fig. 2. Insbesondere ist in der Fig. 3 gezeigt, dass die Statorsensorelemente 8 des Stators 7 das Rotorsensorelement 9 des Rotors 7 zumindest teilweise, überdecken. Insbesondere weist der Rotor 7 eine Aussparung 14 auf, sodass eine zuverlässige Bestimmung der Lage des Rotorsensorelements 9 gegenüber den Statorsensorelementen 8 bestimmt werden kann.

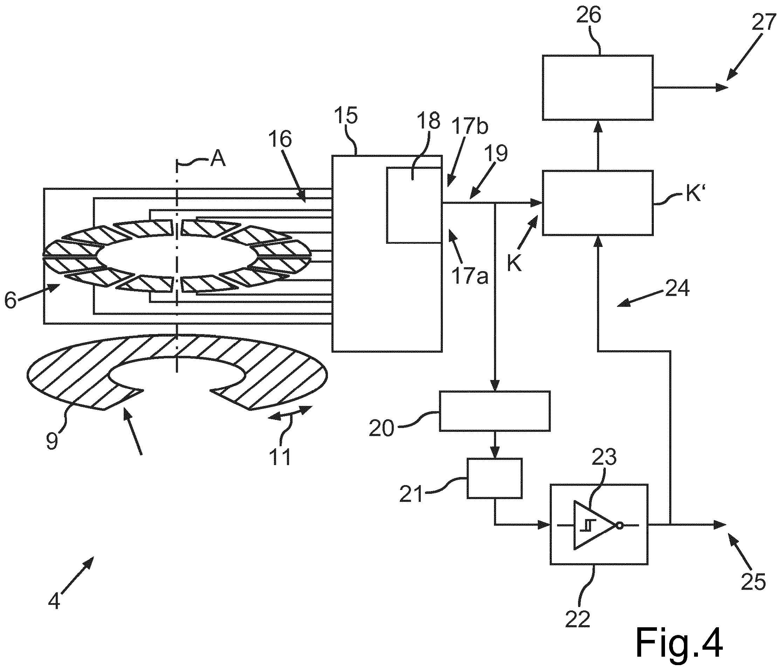

Fig. 4 zeigt in einer schematischen Perspektivansicht eine weitere Ausführungsform der Bedienvorrichtung 4. Insbesondere ist in der Fig. 4 gezeigt, dass Statorkapazitätswerte 16 eines jeden Statorsensorelements 8 über eine Messschaltung 15 aufgenommen werden. Insbesondere erfolgt über eine Analog-Digital-Wandlung 18 eine Erzeugung eines jeweiligen Statorsignals 19. Insbesondere werden mittels eines Summenbilders 20 die Statorkapazitätswerte 16 aufsummiert und mittels eines Bandpasses 21 gefiltert. Insbesondere ist vorgesehen, dass die Statorsignale 19 der Statorkapazitätswertveränderung mit einer Frequenz von > 0,1 Hz und/oder < 100 Hz mittels des Bandpasses 21 herausgefiltert werden. Insbesondere kann mittels des Bandpasses 21 einen Dauerdrückvorgang als Dauerbetätigung erkannt werden und beim Erkennen eines Dauerdrückvorgangs eine Bestimmung des Korrekturwerts K unterdrückt werden.

Ferner weist die Bedienvorrichtung 4 eine Komparatoreinheit 22 mit einer Hysterese 23 auf. Insbesondere kann durch die Komparatoreinheit 22 die erste Betätigungsart 10 detektiert werden. Insbesondere kann mittels der Komparatoreinheit 22 mit der Hysterese 23 eine Mehrfachtriggerung zur Korrektur verhindert werden.

Insbesondere erfolgt in einer Korrektureinheit K` dann die Korrektur der Störgrößen, welche wiederum ein Triggersignal 24 zur Korrekturwertberechnung erhält. An einem Ausgang 25 der Bedienvorrichtung 4 wird ein Rotor-Abhebe-Signal erzeugt. In einer Signalverarbeitung 26 wird die Winkelbestimmung durchgeführt. An einem Ausgang 27 der Bedienvorrichtung wird der Winkel ausgegeben.

Insbesondere ist vorgesehen, dass unter Ausnutzung der Eigenschaft, dass die Bedienvorrichtung 4 als zumindest ein Brennregler-Drehknopf ausgebildet ist, eine zuverlässige Korrektur der Kapazitätswerte 17a, 17b erlaubt werden kann und somit eine zuverlässige Berechnung eines Winkels möglich ist. Insbesondere bei der Ausgestaltungsform des Haushaltsgeräts 1 als Gas-Kochfeld wird ausgenutzt, dass zu Beginn des Kochens das Bedienelement 4 gedrückt werden muss, um den aktuell gültigen Korrekturwert K zu erfassen. Bevor das Bedienelement 5 gedrückt wird, ist eine Winkelerfassung nicht notwendig, da zu diesem Zeitpunkt aufgrund der mechanischen Bauweise des Bedienelements 5 dieser ohnehin in der ersten Ruhestellung steht. Die Winkelerfassung ist erst dann erforderlich, nachdem das Bedienelement 5 zur Zündung gedrückt und dann wieder losgelassen wurde. Ab diesem Zeitpunkt muss der Korrekturwert K der Bedienvorrichtung 4 bekannt sein, um die Kapazitätswerte 17a, 17b und den daraus resultierenden Winkel zuverlässig bestimmen zu können.

Durch das Entfernen des Rotors 7 vom Stator 6 beim Drücken ist es während der Zeit des Drückens als erste Betätigungsart 10 möglich, die Kapazitätswerte 17a, 17b der Statorsensorelemente 8 zu bestimmen, da der Einfluss des Rotors 7 auf die Kapazitätswerte 17a, 17b während dieser Zeit vernachlässigbar klein ist. Damit wird der Korrekturwert K des einzelnen Statorsensorelements 8 kalibriert, was für die spätere Detektion des Rotors 7 erforderlich ist. Beim Loslassen des Bedienelements 5 setzt der Rotor 7 wieder auf den Stator 6 auf, wobei insbesondere zwischen dem Rotor 7 und dem Stator 6 ein vordefinierter Abstand ausgebildet ist. Es findet im Anschluss eine reine Kapazitätswertveränderung aufgrund der Anwesenheit des Rotors 6 und dessen Winkels statt. Diese Kapazitätswertänderung ist weitgehend frei von Störeinflüssen und wird zur Berechnung des Winkels verwendet. Dadurch wird die Winkelbestimmung zuverlässig und genau.

Die Detektion des Rotor-Abhebens muss unabhängig von den Korrekturwerten K geschehen, da die Detektion erfolgen muss, bevor die Korrekturwerte K berechnet werden.

Insbesondere ist vorgesehen, dass die Erkennung des Abhebens des Rotors 7 durch die Verarbeitung der unkorrigierten Statorsignale 19 erfolgt. Dabei wird zunächst die Summe aus allen gemessenen Statorkapazitätswerten 16 gebildet. Dies erfolgt deshalb, weil der Rotor 7 mehrere Statorsensorelemente 8 überdeckt, und nicht bekannt ist, welche Statorsensorelemente 8 aktuell überdeckt werden. Das Summensignal durchläuft danach den Bandpass 21. Dieser ist sperrend für langsame zeitliche Veränderungen der Statorkapazitätswerte 16, welche beispielsweise aufgrund von Driften oder aufgrund von Temperaturveränderungen entstehen. Für schnelle Veränderungen des Signals ist der Bandpass 21 ebenfalls sperrend, da dies Störsignale sind, wie sie beispielsweise durch elektromagnetische Einkopplung von außen geschehen können. Der Bandpass 21 ist durchlässig für Signalveränderungsgeschwindigkeiten, die durch Drücken und Loslassen des Bedienelements 5 entstehen. Genau dieses Drücken und Loslassen wird durch die nachgeschaltete Komparatoreinheit 22 detektiert. Bei dieser ist zum Schalten eine Mindestamplitude erforderlich. Die Komparatoreinheit 22 besitzt die Hysterese 23 und ist derart gestaltet, dass sie im Falle einer Dauerbetätigung, beispielsweise aufgrund von Unterdrückung eines zu langsamen Loslass-Signals durch den Bandpass 21, kein dauerhaft aktives Signal als Rotor-Abhebe-Signal 25 liefert. Insbesondere sind das Rotor-Abhebe-Signal 25 und das Triggersignal 24 gleich ausgebildet.

Insbesondere hat die Bedienvorrichtung 5 den Vorteil, dass eine zuverlässige und genau Bestimmung des Drehknopf-Winkels mit geringem Aufwand durchgeführt werden kann. Des Weiteren entstehen keine Mehrkosten bei der Bedienvorrichtung 5, da die Realisierung durch digitale Signalverarbeitung erfolgt, und es keine zusätzlichen Bauteile erfordert.

### Bezugszeichenliste

- 1: Haushaltsgerät
- 2: Kochfeld
- 3: Kochfeldplatte
- 4: Bedienvorrichtung
- 5: Bedienelement
- 6: Stator
- 7: Rotor
- 8: Statorsensorelement
- 9: Rotorsensorelement
- 10: erste Betätigungsart
- 11: zweite Betätigungsart
- 12: kapazitive Erfassungseinrichtung
- 13: Rückstelleinrichtung
- 14: Ausnehmung
- 15: Messschaltung
- 16: Statorkapazitätswert
- 17a: erster Kapazitätswert
- 17b: zweiter Kapazitätswert
- 18: Analog-Digital-Wandlung
- 19: Statorsignal
- 20: Summenbildung
- 21: Bandpass
- 22: Komparatoreinheit
- 23: Hysterese
- 24: Triggersignal
- 25: Rotor-Abhebe-Signal
- 26: Signalverarbeitung
- 27: Ausgabe des Winkels
- A: Achse
- K: Korrekturwert
- K': Korrektureinheit

## Patentansprüche

1. Verfahren zum Betätigen einer Bedienvorrichtung (4) für ein Haushaltsgerät (1), wobei mittels eines Bedienelements (5) der Bedienvorrichtung (4) durch Betätigen des Bedienelements (5) mit einer ersten Betätigungsart (10) aus einer ersten Ruhestellung in eine erste Bedienstellung eine erste Funktion des Haushaltsgeräts (1) eingestellt wird und durch Betätigen des Bedienelements (5) mit einer zur ersten Betätigungsart (10) unterschiedlichen zweiten Betätigungsart (11) aus einer zweiten Ruhestellung des Bedienelements (4) in zumindest eine von einer Vielzahl von Zwischenstellungen des Bedienelements (4) zum Einstellen eines Werts ein Einstellparameter einer zweiten Funktion des Haushaltsgeräts (1) eingestellt wird, wobei zur Betätigung der ersten Funktion des Haushaltsgeräts (1) zumindest ein erster Kapazitätswert (17a) der Bedienvorrichtung (4) mittels einer kapazitiven Erfassungseinrichtung (12) der Bedienvorrichtung (4) erfasst wird und zur Bestimmung des Einstellparameters zumindest ein zweiter Kapazitätswert (17b) mittels der kapazitiven Erfassungseinrichtung (12) erfasst wird, wobei bei der ersten Betätigungsart (10) aus der ersten Ruhestellung in die erste Bedienstellung der zumindest erste Kapazitätswert (17a) erfasst wird und in Abhängigkeit des erfassten zumindest ersten Kapazitätswerts (17a) zumindest ein Korrekturwert (K) bestimmt wird, welcher bei der Bestimmung des zumindest zweiten Kapazitätswerts (17b) zur Bestimmung des Einstellparameters der zweiten Funktion berücksichtigt wird, wobei die kapazitive Erfassungseinrichtung (12) zumindest einen Rotor (7) mit zumindest einem Rotorsensorelement (9) und einen Stator (6) mit zumindest zwei Statorsensorelementen (8) aufweist, wobei zumindest der erste und der zweite Kapazitätswert (17a, 17b) in Abhängigkeit einer positionellen Veränderung des Rotorsensorelements (9) zu den Statorsensorelementen (8) erzeugt werden, und wobei für ein jeweiliges Statorsensorelement (8) ein jeweiliger Korrekturwert (K) bestimmt wird und bei der Bestimmung und/oder Weiterverarbeitung des zweiten Kapazitätswerts (17b) der jeweilige Korrekturwert (K) eines jeweiligen Statorsensorelements (8) berücksichtigt wird.

2. Verfahren nach Anspruch 1, **dadurch gekennzeichnet, dass** als erste Betätigungsart (10) des Bedienelements (5) das Bedienelement (5) entlang einer Achse (A) des Bedienelements (4) gedrückt wird und als zweite Betätigungsart (11) das Bedienelement (5) um die Achse (A) gedreht wird.

3. Verfahren nach Anspruch 1 oder 2, **dadurch gekennzeichnet, dass** nach dem Betätigen mittels der ersten Betätigungsart (10) des Bedienelements (5) aus der ersten Ruhestellung in die erste Bedienstellung das Bedienelement (5) mittels einer Rückstelleinrichtung (13) der Bedienvorrichtung (4) automatisch in die erste Ruhestellung rückgestellt wird.

4. Verfahren nach einem der vorhergehenden Ansprüche, **dadurch gekennzeichnet, dass** das Betätigen des Bedienelements (5) mittels der ersten Betätigungsart (10) zeitlich vor dem Betätigen des Bedienelements (5) mittels der zweiten Betätigungsart (11) erfolgt und das Bedienelement (5) aus der gleichen Ruhestellung mit der ersten Betätigungsart (10) betätigt wird, aus der das Bedienelement (5) mit der zweiten Betätigungsart (11) auch betätigt wird, so dass die erste Ruhestellung der zweiten Ruhestellung entspricht.

5. Verfahren nach einem der vorhergehenden Ansprüche, **dadurch gekennzeichnet, dass** in Abhängigkeit des zweiten Kapazitätswerts (17b) ein relativer Winkel des Stators (6) zum Rotor (7) bestimmt wird und in Abhängigkeit des Winkels der Einstellparameter eingestellt wird.

6. Verfahren nach einem der Ansprüche 5, **dadurch gekennzeichnet, dass** der erste und der zweite Kapazitätswert (17a, 17b) durch Auswerten von Statorkapazitätswerten (16) der zumindest zwei Statorsensorelemente (8) bestimmt werden.

7. Verfahren nach Anspruch 6, **dadurch gekennzeichnet, dass** der erste Kapazitätswert (17a) durch Aufsummierung der jeweiligen Statorkapazitätswerte (16) beim Betätigen mit der ersten Betätigungsart (10) bestimmt wird.

8. Verfahren nach einem der Ansprüche 6 oder 7, **dadurch gekennzeichnet, dass** zum Bestimmen des ersten Kapazitätswerts (17a) zeitliche Veränderungen der Statorkapazitätswerte (16) als Statorsignale (19) mittels eines Bandpasses (21) gefiltert werden, so dass die erste Betätigungsart (10) erfasst werden kann.

9. Verfahren nach Anspruch 8, **dadurch gekennzeichnet, dass** die Statorsignale (19) der Statorkapazitätswertveränderungen mit einer Frequenz von kleiner 0,1 Hz und/oder größer 100 Hz mittels des Bandpasses (21) herausgefiltert werden.

10. Verfahren nach Anspruch 8 oder 9, **dadurch gekennzeichnet, dass** mittels des Bandpasses (21) ein Dauerdrückvorgang als Dauerbetätigung erkannt wird und beim Erkennen eines Dauerdrückvorgangs eine Bestimmung des Korrekturwerts (K) unterdrückt wird.

11. Verfahren nach einem der Ansprüche 8 bis 10, **dadurch gekennzeichnet, dass** die erste Betätigungsart (10) mittels einer Komparatoreinheit (22) mit einer Hysterese (23) der Bedienvorrichtung (4) detektiert wird.

12. Bedienvorrichtung (4) für ein Haushaltsgerät (1) mit einem Bedienelement (5), welches durch eine erste Betätigungsart (10) und durch eine zur ersten Betätigungsart (10) unterschiedlichen zweiten Betätigungsart (11) betätigbar ist, und mit einer kapazitiven Erfassungseinrichtung (12), welche zumindest einen Rotor (7) mit zumindest einem Rotorsensorelement (9) und einen Stator (6) mit zumindest zwei Statorsensorelementen (8) aufweist, wobei die Bedienvorrichtung (5) dazu ausgebildet ist, ein Verfahren nach einem der Ansprüche 1 bis 11 durchzuführen.

13. Haushaltsgerät (1) zum Zubereiten von Lebensmitteln, insbesondere Gas-Kochfeld, mit Bedienvorrichtung (4) nach Anspruch 12.

## Claims

1. Method for actuating an operating device (4) for a household appliance (1), wherein by means of an operating element (5) of the operating device (4), a first function of the household appliance (1) is set by actuating the operating element (5) with a first actuation type (10) from a first resting position into a first operating position, and for setting a value, a setting parameter of a second function of the household appliance (1) is set by actuating the operating element (5) with a second actuation type (11) which is different from the first actuation type (10), from a second resting position of the operating element (4) into at least one of a plurality of intermediate positions of the operating element (4), wherein in order to actuate the first function of the household appliance (1), at least one first capacitance value (17a) of the operating device (4) is sensed by means of a capacitive sensing apparatus (12) of the operating device (4) and, in order to determine the setting parameter, at least one second capacitance value (17b) is sensed by means of the capacitive sensing apparatus (12), wherein in the case of the first actuation type (10), from the first resting position into the first operating position, the at least first capacitance value (17a) is sensed and at least one correction value (K) is determined in dependence on the sensed at least first capacitance value (17a), which correction value is taken into account in the determination of the at least second capacitance value (17b) in order to determine the setting parameter of the second function, wherein the capacitive sensing apparatus (12) has at least one rotor (7) with at least one rotor sensor element (9) and a stator (6) with at least two stator sensor elements (8), wherein at least the first and the second capacitance value (17a, 17b) are generated in dependence on a positional change of the rotor sensor element (9) relative to the stator sensor elements (8), and wherein one respective correction value (K) is determined for one respective stator sensor element (8) and the respective correction value (K) of one respective stator sensor element (8) is taken into account in the determination and/or further processing of the second capacitance value (17b).

2. Method according to claim 1, **characterised in that**, as the first actuation type (10) of the operating element (5), the operating element (5) is pushed along an axis (A) of the operating element (4) and, as the second actuation type (11), the operating element (5) is rotated about the axis (A).

3. Method according to claim 1 or 2, **characterised in that**, after actuation by means of the first actuation type (10) of the operating element (5) from the first resting position into the first operating position, the operating element (5) is restored automatically into the first resting position by means of a restoring apparatus (13) of the operating device (4).

4. Method according to one of the preceding claims, **characterised in that** the actuation of the operating element (5) by means of the first actuation type (10) takes place chronologically before the actuation of the operating element (5) by means of the second actuation type (11) and the operating element (5) is actuated with the first actuation type (10) from the same resting position from which the operating element (5) is also actuated with the second actuation type (11) so that the first resting position corresponds to the second resting position.

5. Method according to one of the preceding claims, **characterised in that** a relative angle of the stator (6) to the rotor (7) is determined in dependence on the second capacitance value (17b) and the setting parameter is set in dependence on the angle.

6. Method according to claim 5, **characterised in that** the first and the second capacitance value (17a, 17b) are determined by evaluating stator capacitance values (16) of the at least two stator sensor elements (8).

7. Method according to claim 6, **characterised in that** the first capacitance value (17a) is determined by adding up the respective stator capacitance values (16) when actuated with the first actuation type (10).

8. Method according to one of claims 6 or 7, **characterised in that** for determining the first capacitance value (17a) temporal changes to the stator capacitance values (16) are filtered as stator signals (19) by means of a bandpass (21) so that the first actuation type (10) may be sensed.

9. Method according to claim 8, **characterised in that** the stator signals (19) of the stator capacitance value changes at a frequency of less than 0.1 Hz and/or greater than 100 Hz are filtered out by means of the bandpass (21).

10. Method according to claim 8 or 9, **characterised in that** a continuous pushing process is identified as a continuous actuation by means of the bandpass (21) and when a continuous pushing process is identified a determination of the correction value (K) is suppressed.

11. Method according to one of claims 8 to 10, **characterised in that** the first actuation type (10) is detected by means of a comparator unit (22) with a hysteresis (23) of the operating device (4).

12. Operating device (4) for a household appliance (1) having an operating element (5), which is actuatable by a first actuation type (10) and by a second actuation type (11) which is different from the first actuation type (10), and having a capacitive sensing apparatus (12), which has at least one rotor (7) with at least one rotor sensor element (9) and a stator (6) with at least two stator sensor elements (8), wherein the operating device (5) is configured to perform a method according to one of claims 1 to 11.

13. Household appliance (1) for preparing food, in particular a gas hob, having an operating device (4) as claimed in claim 12.

## Revendications

1. Procédé d'actionnement d'un dispositif de commande (4) pour un appareil ménager (1), dans lequel une première fonction de l'appareil ménager (1) est réglée au moyen d'un élément de commande (5) du dispositif de commande (4), par actionnement de l'élément de commande (5) selon un premier type d'actionnement (10) au départ d'une première position de repos vers une première position d'utilisation et un paramètre de réglage d'une deuxième fonction de l'appareil ménager (1) est réglé par l'actionnement de l'élément de commande (5) selon un deuxième type d'actionnement (11) différent du premier type d'actionnement (10) au départ d'une deuxième position de repos de l'élément de commande (4) vers au moins une parmi une pluralité de positions intermédiaires de l'élément de commande (4) pour le réglage d'une valeur, dans lequel pour l'actionnement de la première fonction de l'appareil ménager (1) au moins une première valeur de capacité (17a) du dispositif de commande (4) est saisie au moyen d'un dispositif de saisie capacitif (12) du dispositif de commande (4) et pour la détermination du paramètre de réglage au moins une deuxième valeur de capacité (17b) est saisie au moyen du dispositif de saisie capacitif (12), dans lequel l'au moins une première valeur de capacité (17a) est saisie lors du premier type d'actionnement (10) au départ de la première position de repos vers la première position d'utilisation et en fonction de l'au moins une première valeur de capacité (17a) saisie, au moins une valeur de correction (K) est déterminée, laquelle est prise en compte lors de la détermination de l'au moins une deuxième valeur de capacité (17b) pour la détermination du paramètre de réglage de la deuxième fonction, dans lequel le dispositif de saisie capacitif (12) présente au moins un rotor (7) avec au moins un élément de capteur de rotor (9) et un stator (6) avec au moins deux éléments de capteur de stator (8), dans lequel au moins la première et la deuxième valeur de capacité (17a, 17b) sont générées en fonction d'une modification positionnelle de l'élément de capteur de rotor (9) par rapport aux éléments de capteur de stator (8) et dans lequel pour un élément de capteur de stator (8) respectif une valeur de correction (K) respective est déterminée et la valeur de correction (K) respective d'un élément de capteur de stator (8) respectif est prise en compte lors de la détermination et/ou du traitement de la deuxième valeur de capacité (17b).

2. Procédé selon la revendication 1, **caractérisé en ce que** le premier type d'actionnement (10) de l'élément de commande (5) consiste en une poussée de l'élément de commande (5) le long d'un axe (A) de l'élément de commande (4) et le deuxième type d'actionnement (11) consiste en une rotation de l'élément de commande (5) autour de l'axe (A).

3. Procédé selon la revendication 1 ou 2, **caractérisé en ce qu'**après l'actionnement au moyen du premier type d'actionnement (10) de l'élément de commande (5) au départ de la première position de repos vers la première position d'utilisation, l'élément de commande (5) est automatiquement repositionné dans la première position de repos au moyen d'un dispositif de repositionnement (13) du dispositif de commande (4).

4. Procédé selon l'une des revendications précédentes, **caractérisé en ce que** l'actionnement de l'élément de commande (5) au moyen du premier type d'actionnement (10) s'opère avant l'actionnement de l'élément de commande (5) au moyen du deuxième type d'actionnement (11) et l'élément de commande (5) est actionné au moyen du premier type d'actionnement (10) au départ de la même position de repos que celle au départ de laquelle l'élément de commande (5) est actionné au moyen du deuxième type d'actionnement (11), de sorte que la première position de repos correspond à la deuxième position de repos.

5. Procédé selon l'une des revendications précédentes, **caractérisé en ce qu'**un angle relatif du stator (6) par rapport au rotor (7) est déterminé en fonction de la deuxième valeur de capacité (17b) et le paramètre de réglage réglé en fonction de l'angle.

6. Procédé selon l'une des revendications 5, **caractérisé en ce que** la première et la deuxième valeur de capacité (17a, 17b) sont déterminées par l'évaluation de valeurs de capacité de stator (16) des au moins deux éléments de capteur de stator (8).

7. Procédé selon la revendication 6, **caractérisé en ce que** la première valeur de capacité (17a) est déterminée en totalisant les valeurs de capacité de stator (16) respectives lors de l'actionnement selon le premier type d'actionnement (10).

8. Procédé selon l'une des revendications 6 ou 7, **caractérisé en ce que** pour la détermination de la première valeur de capacité (17a) les variations temporelles des valeurs de capacité de stator (16) sous forme de signaux de stator (19) sont filtrées au moyen d'un filtre passe-bande (21), de sorte que le premier type d'actionnement (10) peut être saisi.

9. Procédé selon la revendication 8, **caractérisé en ce que** les signaux de stator (19) des variations de valeurs de capacité de stator sont filtrés au moyen du filtre passe-bande (21) selon une fréquence inférieure à 0,1 Hz et/ou supérieure à 100 Hz.

10. Procédé selon la revendication 8 ou 9, **caractérisé en ce qu'**un processus de pression en continu est reconnu au moyen du filtre passe-bande (21) sous forme d'actionnement en continu et la détection d'un processus de pression en continu empêche la détermination de la valeur de correction (K).

11. Procédé selon l'une des revendications 8 à 10, **caractérisé en ce que** le premier type d'actionnement (10) est détecté au moyen d'une unité de comparateur (22) avec une hystérèse (23) du dispositif de commande (4).

12. Dispositif de commande (4) pour un appareil ménager (1) avec un élément de commande (5) actionnable par un premier type d'actionnement (10) et par un deuxième type d'actionnement (11) différent du premier type d'actionnement (10), et avec un dispositif de saisie capacitif (12), lequel présente au moins un rotor (7) avec au moins un élément de capteur de rotor (9) et un stator (6) avec au moins deux éléments de capteur de stator (8),dans lequel le dispositif de commande (5) est formé afin d'exécuter un procédé selon l'une des revendications 1 à 11.

13. Appareil ménager (1) pour la préparation de denrées alimentaires, en particulier champ de cuisson à gaz avec un dispositif de commande (4) selon la revendication 12.
